# EUROPEAN PATENT APPLICATION

(11) **EP 3 766 856 A1**
(43) Date of publication of application: **20.01.2021**
(21) Application number: 19837312.8
(22) Date of filing: 03.07.2019
(51) Int. Cl.: C04B 35/491, C01G 33/00, H01L 41/187

(54) **PIEZOELECTRIC CERAMIC, CERAMIC ELECTRONIC COMPONENT, AND PRODUCTION METHOD FOR PIEZOELECTRIC CERAMIC**

(30) Priority: 17.07.2018 JP 2018134499
(71) Applicant: Murata Manufacturing Co., Ltd., Nagaokakyo-shi, Kyoto 617-8555 (JP)
(72) Inventor: KANAMORI, Yuki, Nagaokakyo-shi, Kyoto 617-8555 (JP)
(74) Representative: Zimmermann, Tankred Klaus
(86) International application number: PCT/JP2019/026405
(87) International publication number: WO 2020/017325

(57) **Abstract**

A piezoelectric ceramic containing a perovskite-type compound containing at least Pb, Zr, Ti, Mn, and Nb, in which in an X-ray crystal structure analysis chart of the perovskite-type compound, there is no X-ray diffraction peak branching between a (101) plane on which an X-ray diffraction peak, which is a main peak of a PZT tetra phase, is detected in a range of 2θ = 30.5° or more, 31.5° or less and a (110) plane on which an X-ray diffraction peak is detected in a range of 2θ = 30.8° or more, 31.8° or less, and a number of X-ray diffraction peaks appearing based on the (101) plane and the (110) plane is one.

## Description

### TECHNICAL FIELD

The present invention relates to a piezoelectric ceramic, a ceramic electronic component, and a method of manufacturing a piezoelectric ceramic.

### BACKGROUND ART

In recent years, there have been strong demands for downsizing of mobile terminals, thinning of televisions, and the like, and further reduction in size/height of electronic components is required. A piezoelectric resonance-driven high power device is considered to be advantageous for reduction in size/height because large displacement can be obtained at low voltage. Lead zirconate titanate (hereinafter referred to as "PZT") having good piezoelectric characteristics is widely used as a ceramic material used in this type of piezoelectric ceramic electronic component.

Incidentally, in the above-mentioned piezoelectric resonant-driven high power device, if Vₘₐₓ (limited vibration speed) in resonant driving is low, thermal runaway occurs during driving to cause a rapid temperature rise, and the life of the piezoelectric ceramic is remarkably reduced. Further, in a piezoelectric transformer, heat generated during driving may also affect peripheral circuits, which may lead to deterioration of device characteristics. Therefore, in order to suppress thermal runaway during driving, it is necessary to increase Vₘₐₓ in resonant driving.

Patent Document 1 discloses a piezoelectric ceramic composition containing a multi-component PZT as a main component. Patent Document 2 also discloses a piezoelectric ceramic composition, and describes that a piezoelectric ceramic composition is produced by firing a molded product at a temperature of 1300°C or higher.

### PRIOR ART DOCUMENTS

### PATENT DOCUMENTS

Patent Document 1: Japanese Patent Application Laid-Open No. 2006-199524
Patent Document 2: Japanese Patent Application Laid-Open No. 2017-165618

### SUMMARY OF THE INVENTION

### Problem to be solved by the invention

In a PZT-based piezoelectric body as in Patent Document 1, a high piezoelectric constant can be expected by substituting a part of Pb with Sr having a low electronegativity. However, in resonant driving, since Sr ions that are easy to move are present, problems such as a decrease in Vₘₐₓ and an increase in heat generation due to a decrease in Qₘ are likely to occur, which is not preferable from the viewpoint of extending the life of the piezoelectric ceramic.

Further, it is described in "0031" of Patent Document 1 that "a factor for improving Kᵣ characteristic is considered to be an effect of crystal grain growth of ceramics", and it is presumed that the piezoelectric ceramic composition obtained in Patent Document 1 has high crystallinity.

In Patent Document 2, by substituting La for an A site of PZT, improvement in Qₘ can be expected as compared with the case of Sr substitution. However, since this material is difficult to sinter, it needs to be fired at a high temperature of 1300°C as a top temperature. Under high temperature firing, it is considered that sinter diffusion rapidly progresses, the atomic concentration increases, and crystal nucleation is accelerated to promote crystallization. As crystallization proceeds, 90° domain inversion increases, and heat generation increases and Vₘₐₓ decreases due to Qₘ decrease during resonant large-amplitude driving, and extending the life of the piezoelectric ceramic cannot be expected.

The present invention has been made in view of such circumstances, and has an object to provide a piezoelectric ceramic suppressing heat generation by increasing Qₘ during resonant large-amplitude driving and capable of achieving a long life by increasing Vₘₐₓ, a ceramic electronic component using the piezoelectric ceramic, and a method of manufacturing a piezoelectric ceramic.

### Means for solving the problem

The piezoelectric ceramic of the present invention contains a perovskite-type compound containing at least Pb, Zr, Ti, Mn, and Nb, in which in an X-ray crystal structure analysis chart of the perovskite-type compound, there is no X-ray diffraction peak branching between a (101) plane on which an X-ray diffraction peak, which is a main peak of a PZT tetra phase, is detected in a range of 2θ = 30.5° or more, 31.5° or less and a (110) plane on which an X-ray diffraction peak is detected in a range of 2θ = 30.8° or more, 31.8° or less, and a number of X-ray diffraction peaks appearing based on the (101) plane and the (110) plane is one.

A ceramic electronic component of the present invention is characterized by including a piezoelectric body containing the piezoelectric ceramic of the present invention and an external electrode.

The first embodiment of a method of manufacturing a piezoelectric ceramic of the present invention includes: a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material; a molding step of molding the ceramic calcined powder into a ceramic compact; and a firing step of firing the ceramic compact to obtain a sintered body, in which the firing step is performed in a high oxygen atmosphere having an oxygen partial pressure of 9.87 × 10⁻² MPa or more, 1.01 × 10⁻¹ MPa or less.

The second embodiment of the method of manufacturing a piezoelectric ceramic of the present invention includes: a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material; a pulverizing step of pulverizing the ceramic calcined powder; a molding step of molding the pulverized ceramic calcined powder into a ceramic compact; and a firing step of firing the ceramic compact to obtain a sintered body.

### Advantageous effect of the invention

According to the present invention, it is possible to provide a piezoelectric ceramic suppressing heat generation by increasing Qₘ during resonant large-amplitude driving and capable of achieving a long life by increasing Vₘₐₓ.

### BRIEF EXPLANATION OF DRAWINGS

FIG. 1 is a sectional view schematically showing an example of a first embodiment of a ceramic electronic component.
FIG. 2 is a sectional view schematically showing an example of a second embodiment of a ceramic electronic component.
FIG. 3 is a sectional view schematically showing an example of a third embodiment of a ceramic electronic component.
FIG. 4 is an electron microscope photograph of the piezoelectric ceramic produced in Sample number 3. FIG. 5 is a diagram comparing X-ray diffraction peaks of piezoelectric ceramic single plates produced in Sample numbers 1 to 4.
FIG. 6 is a diagram comparing X-ray diffraction peaks of piezoelectric ceramic single plates produced in Sample numbers 2, 5, and 6.
FIG. 7 is a graph showing a relationship between a vibration speed and Qₘ of the piezoelectric ceramics produced in Sample numbers 1 to 4 in resonant driving.
FIG. 8 is a graph showing a relationship between a vibration speed and Qₘ of the piezoelectric ceramics produced in Sample numbers 2, 5, and 6 in resonant driving.
FIG. 9 is a graph showing a relationship between a vibration speed and heat generation in resonant driving of the piezoelectric ceramics produced in Sample numbers 1 to 4.
FIG. 10 is a graph showing a relationship between a vibration speed and heat generation in resonant driving of the piezoelectric ceramics produced in Sample numbers 2, 5, and 6.

### MODE FOR CARRYING OUT THE INVENTION

Hereinafter, a piezoelectric ceramic, a ceramic electronic component, and a method of manufacturing a piezoelectric ceramic of the present invention will be described. However, the present invention is not limited to the following configurations, and can be appropriately modified and applied within a range not departing from the scope of the present invention. It should be noted that a combination of two or more of the respective desirable configurations of the present invention described below is also the present invention.

### <Piezoelectric ceramic>

The piezoelectric ceramic of the present invention contains a perovskite-type compound containing at least Pb, Zr, Ti, Mn, and Nb, in which in an X-ray crystal structure analysis chart of the perovskite-type compound, there is no X-ray diffraction peak branching between a (101) plane on which an X-ray diffraction peak, which is a main peak of a PZT tetra phase, is detected in a range of 2θ = 30.5° or more, 31.5° or less and a (110) plane on which an X-ray diffraction peak is detected in a range of 2θ = 30.8° or more, 31.8° or less, and a number of X-ray diffraction peaks appearing based on the (101) plane and the (110) plane is one.

In a crystal of the perovskite type compound containing Pb, Zr, Ti, Mn, and Nb, in the X-ray crystal structure analysis chart, an X-ray diffraction peak based on the (101) plane is detected in a range of 2θ = 30.5° or more, 31.5° or less. Further, an X-ray diffraction peak based on the (110) plane is detected in a range of 2θ = 30.8° or more, 31.8° or less. When a crystallinity of the perovskite type compound is high, the X-ray diffraction peak based on the (101) plane and the X-ray diffraction peak based on the (110) plane are detected in a clearly distinguishable manner. On the other hand, when the crystallinity of the perovskite type compound is low, there is no peak branching between the X-ray diffraction peak based on the (101) plane and the X-ray diffraction peak based on the (110) plane, and the number of X-ray diffraction peaks appearing based on the (101) plane and the (110) plane is one. That is, the perovskite type compound that constitutes the piezoelectric ceramic of the present invention is a compound having low crystallinity.

In the piezoelectric ceramic of the present invention, in the X-ray crystal structure analysis chart of the perovskite type compound, it is preferable that one X-ray diffraction peak based on the (101) plane and the (110) plane appears at a position of 2θ = 30.8° or more, 31.2° or less. This position is a position slightly shifted from a peak position based on the (101) plane of the PZT tetra phase, and at this position, a boundary between the peaks based on the (101) plane and the (110) plane disappears, and one X-ray diffraction peak appears.

The X-ray crystal structure analysis can be performed using a commonly used X-ray crystal structure analysis device. For example, it can be measured by the following device and measurement conditions. Tube: CuKα Tube voltage: 45 kV Tube current: 200 mA Scan angle: 10-70° Sampling width: 0.02° Optical system: Concentration method optical system

The perovskite-type compound that constitutes the piezoelectric ceramic of the present invention has low crystallinity, and when the piezoelectric characteristic is measured as a ceramic electronic component, Qₘ drop is suppressed in a high vibration speed region. Then, the limited vibration speed (Vₘₐₓ) becomes high. Conventionally, in order to improve the piezoelectric characteristics of a ceramic electronic component using piezoelectric ceramic, it has been common to grow crystal grains of a compound constituting the piezoelectric ceramic so as to enhance crystallinity. However, improving the piezoelectric characteristics by using a compound having a low crystallinity has been a method that cannot be predicted from the related art.

The piezoelectric ceramic of the present invention contains a perovskite-type compound containing Pb, Zr, Ti, Mn, and Nb, and has a composition in which at least Mn and Nb are added to the PZT ceramic. The content of Mn in the perovskite-type compound is preferably 0.019 mol% or more, 0.041 mol% or less. The Nb content in the perovskite-type compound is preferably 0.048 mol% or more, 0.057 mol% or less.

In addition, trace amounts of Hf, Fe, Cl, Si, Al and the like may be included as unavoidable impurities as long as the characteristics of the piezoelectric ceramic of the present invention are not impaired.

The piezoelectric ceramic of the present invention preferably has a mechanical quality factor Qₘ as a material of 800 or more at a vibration speed of 0.55 m/s. Further, the piezoelectric ceramic of the present invention preferably has a limited vibration speed (Vₘₐₓ) as a material of 0.8 m/s or more.

The characteristics of the piezoelectric ceramic of the present invention can be measured as follows. (1) The piezoelectric ceramic is cut into a shape of 13 mm length × 3 mm width × 0.9 mm thickness for evaluation of piezoelectric characteristics by a dicer. (2) The cut sample is subjected to polarization treatment for 30 minutes under conditions of a temperature of 150°C and an electric field strength of 3 kV/mm using an oil bath or the like. (3) The relative permittivity (ε₃₃^{T}/ε₀) and the electromechanical coupling coefficient (k₃₁) in a minute electric field can be measured by the resonance-antiresonance method, using an impedance analyzer (Agilent Technologies-made: 4294A), and conforming to the Japan Electronic Material Industry Association standard (EMAS - 6100). (4) The mechanical quality factor (Qₘ), the limited vibration speed (Vₘₐₓ), and the elastic compliance (S₁₁^{E}) in resonance drive are measured by the constant current measurement method. The limited vibration speed is defined as the vibration speed when the temperature rise at a vibration node of an oscillator reaches 20°C under resonance drive at room temperature.

### <Method of manufacturing piezoelectric ceramic>

Then, the method of manufacturing a piezoelectric ceramic of this invention is described. The method of manufacturing a piezoelectric ceramic of the present invention includes two embodiments, and the first embodiment is characterized by performing a firing step in a high oxygen atmosphere having an oxygen partial pressure of 9.87 × 10 ⁻² MPa or more, 1.01 × 10⁻¹ MPa or less. The second embodiment is characterized by performing a pulverizing step of pulverizing the ceramic calcined powder. The piezoelectric ceramic of the present invention can be obtained by any method.

### (First Embodiment of Method of Manufacturing Piezoelectric Ceramic)

The first embodiment of a method of manufacturing a piezoelectric ceramic of the present invention includes: a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material; a molding step of molding the ceramic calcined powder into a ceramic compact; and a firing step of firing the ceramic compact to obtain a sintered body, in which the firing step is performed in a high oxygen atmosphere having an oxygen partial pressure of 9.87 × 10⁻² MPa or more, 1.01 × 10⁻¹ MPa or less.

### [Ceramic calcined powder producing step]

A ceramic raw material containing at least a Pb compound, a Zr compound, a Ti compound, an Mn compound, and an Nb compound is prepared. The form of these compounds is not particularly limited, and compounds in the form of oxides, carbonates, chlorides, hydroxides, metal organic compounds or the like of each metal can be used. The above ceramic raw material is weighed so that these compounds have a predetermined composition ratio after sintering. Then, these weighed materials are put into a ball mill or the like in which a pulverizing medium such as partially stabilized zirconia is contained, and a wet mixing process is sufficiently carried out using pure water, an organic solvent or the like as a solvent, and after dehydration, in an air atmosphere, calcination is performed at a temperature of 930°C or more, 1080°C or less to produce a ceramic calcined powder.

### [Molding step]

Next, after the ceramic raw material powder is crushed, an organic binder such as a polyvinyl alcohol resin is added, and medialess wet dispersion mixing is performed, or wet pulverizing is performed with a ball mill or the like having a pulverizing medium therein, thereby producing a slurry. Then, this is spray-dried to produce granulated powder for molding. A ceramic compact is produced by molding this granulated powder.

### [Firing/degreasing treatment]

The ceramic compact is put into a sheath, placed in a furnace, and subjected to firing/degreasing treatment. The firing/degreasing treatment is performed in a muffle furnace or the like under an air atmosphere. As the firing profile, the furnace temperature is raised to a predetermined temperature (for example, 400°C or more, 500°C or less) at a predetermined temperature rising rate (for example, 0.5°C/min or more, 4°C/min or less), degreasing is performed for a predetermined time (for example, 1 hour or more, 3 hours or less), and the firing/degreasing treatment is completed by lowering the temperature at a predetermined temperature decreasing rate (for example, 1°C/min or more, 6°C/min or less). The firing/degreasing treatment is an optional step.

### [Firing step]

Next, main firing (firing step) is performed. The firing step is performed in a high oxygen atmosphere having an oxygen partial pressure of 9.87 × 10⁻² MPa or more, 1.01 × 10⁻¹ MPa or less. As the firing profile, the furnace temperature is raised to a predetermined temperature (for example, 250°C or more, 350°C or less) at a predetermined temperature rising rate (for example, 0.5°C/min or more, 4°C/min or less), the temperature is held for a predetermined time (for example, 1 hour or more, 3 hours or less) and the firing atmosphere is substituted by O₂ to make the high oxygen atmosphere, then the furnace temperature is raised to a predetermined firing temperature (for example, 1100°C or more, 1250°C or less) at a predetermined temperature rising rate (for example, 0.5°C or more, 4°C/min or less), and after the temperature is held for a predetermined time (for example, 6 hours or more, 10 hours or less), the temperature is lowered at a predetermined temperature decreasing rate (for example, 1°C/min or more, 6°C/min or less), thereby completing the firing process to give a piezoelectric ceramic. Further, the firing temperature in the firing step is more preferably 1060°C or more, 1200°C or less. A firing temperature of 1060°C or more is preferable from the viewpoint of densifying the piezoelectric ceramic, and a piezoelectric ceramic having a low porosity can be obtained.

When firing is performed under high oxygen partial pressure using O₂ gas (in an atmosphere having an oxygen partial pressure of 9.87 × 10⁻² MPa or more, 1.01 × 10⁻¹ MPa or less), a perovskite-type compound having low crystallinity is obtained in which there is no X-ray diffraction peak branching between a (101) plane and a (110) plane of the PZT tetra phase, and the number of X-ray diffraction peaks appearing based on the (101) plane and the (110) plane is one. This is presumed to be due to low crystallization because the solid solution of the Mn component in a B site of the PZT-based perovskite-type compound was suppressed and the oxygen vacancies were reduced accordingly, thereby suppressing the sintering.

### (Second embodiment of Method of Manufacturing Piezoelectric Ceramic)

The second embodiment of the method of manufacturing a piezoelectric ceramic of the present invention includes: a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material; a pulverizing step of pulverizing the ceramic calcined powder; a molding step of molding the pulverized ceramic calcined powder into a ceramic compact; and a firing step of firing the ceramic compact to obtain a sintered body. In this embodiment, the steps up to the [ceramic calcined powder producing step] can be performed in the same manner as in the first embodiment described above, so the subsequent steps (steps after the pulverizing step) will be described.

### [Pulverizing step]

In the pulverizing step, after the ceramic calcined powder is crushed, a dispersant and an antifoaming agent are added, and wet pulverizing is performed for a predetermined time (for example, 10 hours or more, 40 hours or less) in a container containing partially stabilized zirconia balls, thereby producing a slurry. By performing the pulverizing step, the crystallinity of the calcined powder can be reduced, and thus it is possible to obtain a piezoelectric ceramic which is a perovskite-type compound having low crystallinity. In the pulverizing step, it is preferable to perform pulverization so that a specific surface area by the BET method becomes 2.9 to 5.3 m²/g.

### [Molding step]

In the molding step, a ceramic compact (cast compact) is obtained by filling this slurry in a resin casting mold and drying it for a predetermined time (for example, 20 hours or more, 28 hours or less).

### [Firing/degreasing treatment]

This cast compact is put in a sheath, placed in a furnace, and subjected to firing/degreasing treatment. The firing/degreasing treatment is performed in a muffle furnace or the like under an air atmosphere. As the firing profile, the furnace temperature is raised to a predetermined temperature (for example, 70°C or more, 80°C or less) at a predetermined temperature rising rate (for example, 0.5°C/min or more, 4°C/min or less), then the temperature is raised to a predetermined temperature (for example, 350°C or more, 450°C or less) at a predetermined temperature rising rate (for example, 0.2°C/min or more, 0.5°C/min or less) and held for a predetermined time (for example, 1 hour or more, 3 hours or less), then the temperature is further raised to a predetermined temperature (for example, 550°C or more, 650°C or less) at a predetermined temperature rising rate (for example, 2°C/min or more, 4°C/min or less) and held for a predetermined time (for example, 0.5 hours or more, 1.5 hours or less), and then the temperature is lowered at a predetermined temperature decreasing rate (for example, 1°C/min or more, 5°C/min or less), thereby completing the firing/degreasing treatment. The firing/degreasing treatment is an optional step.

### [Firing step]

Next, main firing (firing step) is performed. As the firing profile, the furnace temperature is raised to a predetermined temperature (for example, 250°C or more, 350°C or less) at a predetermined temperature rising rate (for example, 0.5°C/min or more, 4°C/min or less) and held for a predetermined time (for example, 1 hour or more, 3 hours or less), the firing atmosphere is substituted by N₂, then the furnace temperature is raised to a predetermined temperature (for example, 1030°C or more, 1200°C or less) at a predetermined temperature rising rate (for example, 0.5°C/min or more, 4°C/min or less) and held for a predetermined time (for example, 6 hours or more, 10 hours or less), and then the temperature is lowered at a predetermined temperature decreasing rate (for example, 1°C/min or more, 6°C/min or less), thereby completing the main firing treatment.

The furnace atmosphere in the firing step is preferably a low oxygen atmosphere using N₂ gas and having an oxygen partial pressure of 5.74 × 10⁻⁷ MPa or more, 3.28 × 10⁻⁶ MPa or less. In addition, it is also preferably performed in a low oxygen atmosphere having an oxygen partial pressure of 1.04 × 10⁻⁹ MPa or more, 1.20 × 10⁻⁸ MPa or less, which is a combination of H₂/N₂ mixed gas and water drop (hereinafter also abbreviated as WD). When performing the firing step in such an atmosphere, it is preferable that the piezoelectric ceramic be densified at a low temperature by firing at 1050°C or more. By densifying at a low temperature, the growth of crystal nuclei can be suppressed, and thus a perovskite-type compound having low crystallinity can be obtained.

Further, the firing step may be performed in a high oxygen atmosphere having an oxygen partial pressure of 9.87 × 10 ⁻² MPa or more, 1.01 × 10⁻¹ MPa or less. In this case, the step is a combination of the first and second embodiments of the method of manufacturing a piezoelectric ceramic of the present invention, and in this case also, a perovskite-type compound having low crystallinity can be obtained.

### <Ceramic electronic component>

A ceramic electronic component of the present invention is characterized by including a piezoelectric body containing the piezoelectric ceramic of the present invention and an external electrode.

It is preferable that the piezoelectric body be a piezoelectric ceramic electronic component which has an input portion and an output portion, and in which a voltage signal supplied to the input portion is output from the output portion with its voltage transformed.

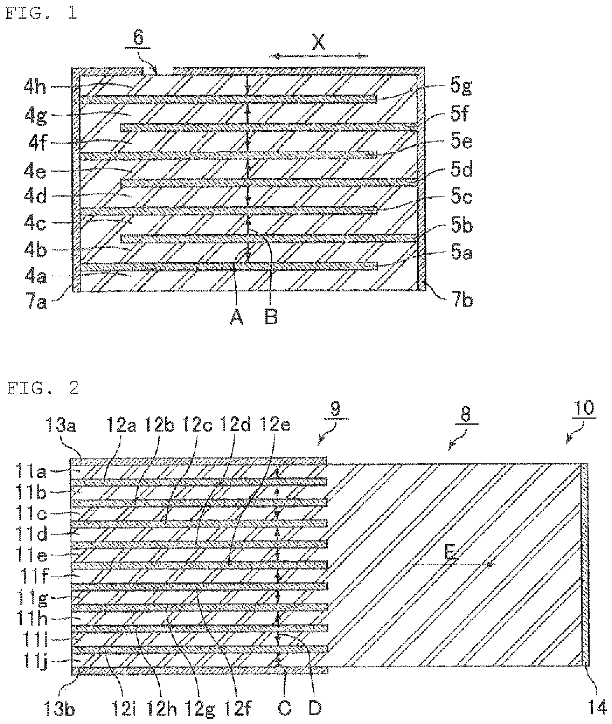

Hereinafter, an example of the ceramic electronic component will be described. FIG. 1 is a sectional view schematically showing an example of a first embodiment of a ceramic electronic component. An example of a piezoelectric actuator is shown as the first embodiment.

This piezoelectric actuator has a laminated sintered body 6 provided with piezoelectric bodies 4a to 4h and internal electrodes 5a to 5g formed of the piezoelectric ceramic of the present invention, and external electrodes 7a and 7b are formed on an outer surface of the laminated sintered body 6. The piezoelectric bodies 4b, 4d, 4f, and 4h are polarized in an arrow A direction, and the piezoelectric bodies 4c, 4e, and 4g are polarized in an arrow B direction. That is, the piezoelectric bodies 4b to 4h are configured such that polarization directions are opposite for each layer.

In the laminated sintered body 6, the piezoelectric bodies 4a to 4h, and the internal electrodes 5a to 5g are alternately laminated, and the internal electrodes 5a, 5c, 5e, and 5g are electrically connected to one external electrode 7a, and the internal electrodes 5b, 5d, and 5f are electrically connected to the other external electrode 7b.

An internal electrode material and an external electrode material are not particularly limited, but Ag and Ag-Pd can be preferably used.

In this piezoelectric actuator, when a voltage is applied to the external electrode 7a and the external electrode 7b, the piezoelectric actuator is displaced in an arrow X direction by an inverse piezoelectric effect, mechanical energy is taken out, and various electronic devices can be controlled with high accuracy.

In the first embodiment, since the piezoelectric bodies 4a to 4h are formed of the piezoelectric ceramic of the present invention, the mechanical quality factor Qₘ is high, and the limited vibration speed Vₘₐₓ is high, so that self-heating is suppressed, the life of the piezoelectric actuator can be extended, and stable piezoelectric characteristics can be secured.

This piezoelectric actuator can be manufactured as follows.

A conductive paste to be an internal electrode and an external electrode is prepared. Further, a ceramic green sheet is produced by using the slurry used in the molding step of the method of manufacturing a piezoelectric ceramic of the present invention described above. The conductive paste is applied to the surface of this ceramic green sheet by a screen printing method or the like to form a predetermined conductive pattern. Next, after laminating the ceramic green sheets having the conductive patterns formed in a predetermined direction, the ceramic green sheets having no conductive patterns formed thereon are placed on the uppermost layer and thermocompression bonded to produce a laminated molded body. The steps up to here correspond to the molding step in the method of manufacturing a piezoelectric ceramic of the present invention.

Next, the firing/degreasing treatment (optional step) and the firing step in the method of manufacturing a piezoelectric ceramic of the present invention are performed on the laminated molded body to give a laminated sintered body 6 in which the piezoelectric bodies 4a to 4h and the internal electrodes 5a to 5g are alternately arranged. At this stage, the piezoelectric ceramic of the present invention is manufactured in the laminated sintered body.

After that, the external electrodes 7a and 7b are formed on the outer surface of the laminated sintered body 6 by using a vacuum vapor deposition method or the like. Then, under heating, an electric field is applied to the external electrodes 7a and 7b for a predetermined time to perform polarization treatment in the arrow A direction and the arrow B direction, thereby producing a piezoelectric actuator.

FIG. 2 is a sectional view schematically showing an example of a second embodiment of the ceramic electronic component. An example of a piezoelectric transformer is shown as the second embodiment.

In this piezoelectric transformer, a piezoelectric body 8 formed of the piezoelectric ceramic of the present invention has an input portion 9 and an output portion 10, and a voltage signal supplied to the input portion 9 is output from the output portion 10 with its voltage transformed.

Specifically, the input portion 9 has a laminated structure in which piezoelectric bodies 11a to 11j and internal electrodes 12a to 12i are alternately laminated, and input electrodes 13a and 13b, which are external electrodes, are formed on an upper surface of the piezoelectric body 11a and a lower surface of the piezoelectric body 11j, and the internal electrodes 12a to 12h are electrically connected to the input electrodes 13a and 13b. The piezoelectric bodies 11a, 11c, 11e, 11g, and 11i are polarized in an arrow D direction, and the piezoelectric bodies 11b, 11d, 11f, 11h, and 11j are polarized in an arrow C direction. That is, the piezoelectric bodies 11a to 11j are configured such that the polarization directions are opposite for each layer.

Further, the output portion 10 has a single-layer structure having no internal electrode, an output electrode 14, which is an external electrode, is formed on one end surface, and is polarized in an arrow E direction.

In the piezoelectric transformer formed in this manner, when an AC voltage having a resonance frequency is applied to the input electrodes 13a and 13b, it is converted into mechanical energy by the inverse piezoelectric effect and mechanical vibration is excited. Next, this mechanical vibration is converted into electric energy by the piezoelectric effect, and a voltage signal boosted according to the capacitance ratio between the input portion 9 and the output portion 10 is output from the output electrode 14.

In the second embodiment, since the piezoelectric bodies 8 and 11a to 11j are formed of the piezoelectric ceramic of the present invention, the mechanical quality factor Qₘ is high, and the limited vibration speed Vₘₐₓ is high, so that self-heating is suppressed, the life of the piezoelectric transformer can be extended, and stable piezoelectric characteristics can be secured.

Also in the second embodiment, the internal electrode material and the external electrode material are not particularly limited, but Ag and Ag-Pd can be preferably used.

Further, this piezoelectric transformer can be manufactured as follows, like the piezoelectric actuator described above.

A conductive paste to be an internal electrode and an external electrode is prepared. Further, a ceramic green sheet is produced by using the slurry used in the molding step of the method of manufacturing a piezoelectric ceramic of the present invention described above. The conductive paste is applied to the surface of this ceramic green sheet by a screen printing method or the like to form a predetermined conductive pattern on a portion corresponding to the input portion 9. Next, a predetermined number of ceramic green sheets on which conductive patterns are formed are laminated, and then thermocompression bonded to produce a laminated molded body. The steps up to here correspond to the molding step in the method of manufacturing a piezoelectric ceramic of the present invention.

Next, the firing/degreasing treatment (optional step) and the firing step in the method of manufacturing a piezoelectric ceramic of the present invention are performed on the laminated molded body to give a sintered body in which the input portion 9 has a laminated structure in which the piezoelectric bodies 11a to 11j and the internal electrodes 12a to 12i are alternately arranged, and the output portion 10 has a single-layer structure. At this stage, the piezoelectric ceramic of the present invention is manufactured in the sintered body.

After that, the input electrodes 13a and 13b as external electrodes are formed on the upper surface and the lower surface of the input portion 9 by using a vacuum deposition method or the like, and the output electrode 14 as an external electrode is further formed on the end surface of the output portion 10. Then, under heating, an electric field is applied between the input electrodes 13a, 13b and the output electrode 14 for a predetermined time to polarize the output portion 10 in the arrow E direction. Further, under heating to a predetermined temperature, an electric field is applied for a predetermined time between the input electrode 13a and the input electrode 13b so that the polarization directions of the input portion 9 are opposite for each layer, and the polarization treatment is performed, thereby producing a piezoelectric transformer.

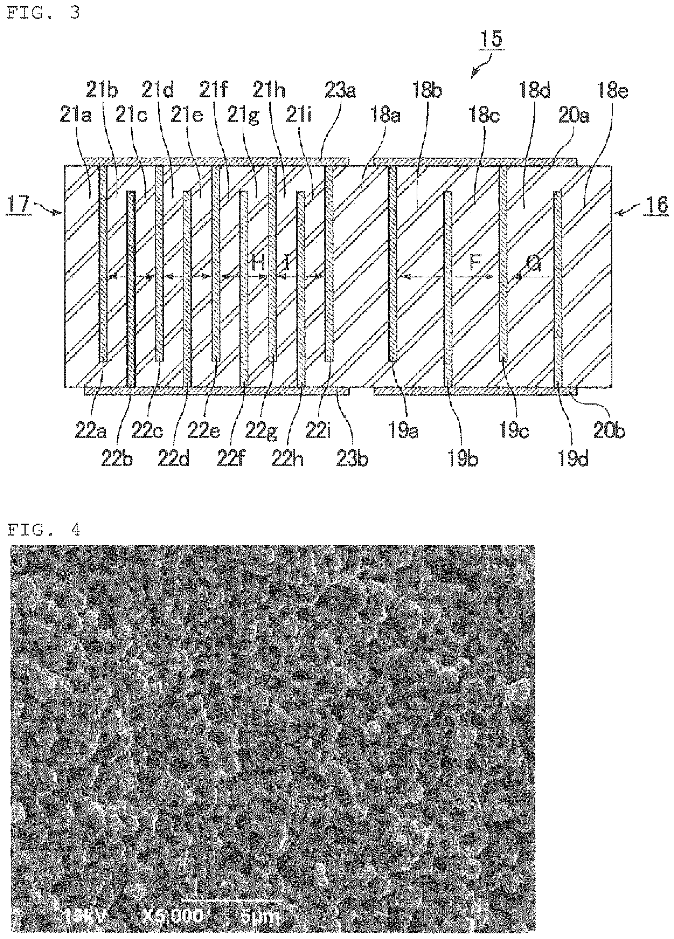

FIG. 3 is a sectional view schematically showing an example of a third embodiment of the ceramic electronic component. As the third embodiment, another example of the piezoelectric transformer is shown.

Also in the third embodiment, similarly to the second embodiment, the piezoelectric body 15 formed of the piezoelectric ceramic of the present invention has an input portion 16 and an output portion 17, and is configured such that a voltage signal supplied to the input portion 16 is output from the output portion 17 with its voltage transformed.

In this piezoelectric transformer, both the input portion 16 and the output portion 17 have a laminated structure having internal electrodes, and the input portion 16 and the output portion 17 have different inter-electrode distances. That is, the input portion 16 has a laminated structure in which the piezoelectric bodies 18a to 18e and the internal electrodes 19a to 19d are alternately laminated, and the input electrodes 20a and 20b are formed on the side surfaces of the input portion 16. Specifically, the internal electrodes 19a and 19c are electrically connected to one input electrode 20a, and the internal electrodes 19b and 19d are electrically connected to the other input electrode 20b. Then, the piezoelectric bodies 18b to 18d are polarized in an arrow F direction or an arrow G direction so that the polarization directions are opposite for each layer.

On the other hand, the output portion 17 has a laminated structure in which piezoelectric bodies 21a to 21i and internal electrodes 22a to 22i are alternately laminated, and output electrodes 23a and 23b are formed on the side surfaces of the output portion 17. Specifically, the internal electrodes 22a, 22c, 22e, 22g, and 22i are electrically connected to one output electrode 23a, and the internal electrodes 22b, 22d, 22f, and 22h are electrically connected to the other output electrode 23b. Then, the piezoelectric bodies 21b to 21i are polarized in an arrow H direction or an arrow I direction so that the polarization directions are opposite for each layer.

Then, in the third embodiment, the inter-electrode distances of the internal electrodes are made different between the output portion 17 and the output portion 16 so that the inter-electrode distance of the internal electrodes 22a to 22i of the output portion 17 is shorter than the inter-electrode distance of the internal electrodes 19a to 19d of the input portion 16.

In the piezoelectric transformer formed in this manner, when an AC voltage having a resonance frequency is applied to the input electrodes 20a and 20b, it is converted into mechanical energy by the inverse piezoelectric effect and mechanical vibration is excited. Next, this mechanical vibration is converted into electric energy by the piezoelectric effect, and the voltage signal stepped down according to the capacitance ratio is output from the output electrodes 23a and 23b.

Then, in the third embodiment, since the piezoelectric bodies 18a to 18e and 21a to 21i are formed of the piezoelectric ceramic of the present invention, similarly to the second embodiment, the mechanical quality factor Qₘ is high, and the limited vibration speed Vₘₐₓ is high, so that self-heating is suppressed, the life of the piezoelectric transformer can be extended, and stable piezoelectric characteristics can be secured.

Also in the third embodiment, the internal electrode material and the external electrode material are not particularly limited, but Ag and Ag-Pd can be preferably used.

Further, this piezoelectric transformer can be manufactured as follows, like the piezoelectric actuator and the piezoelectric transformer described above.

A conductive paste to be an internal electrode and an external electrode is prepared. Further, two kinds of ceramic green sheets having different thicknesses (input ceramic green sheet and output ceramic green sheet) are produced by using the slurry used in the molding step of the method of manufacturing a piezoelectric ceramic of the present invention described above. A conductive paste is applied to the surface of these ceramic green sheets by a screen printing method or the like to form a predetermined conductive pattern. Next, a predetermined number of the ceramic green sheets having the conductive patterns formed thereon are laminated, and then the ceramic green sheets having no conductive patterns formed thereon are arranged on both ends and thermocompression bonded to produce a laminated molded body. The steps up to here correspond to the molding step in the method of manufacturing a piezoelectric ceramic of the present invention.

Next, the firing/degreasing treatment (optional step) and the firing step in the method of manufacturing a piezoelectric ceramic of the present invention are performed on the laminated molded body to give a sintered body in which the input portion 16 has a laminated structure in which the piezoelectric bodies 18a to 18e and the internal electrodes 19a to 19d are alternately arranged, and the output portion 17 has a laminated structure in which the piezoelectric bodies 21a to 21i and the internal electrodes 22a to 22i are alternately arranged, and the inter-electrode distances of the internal electrodes are different. At this stage, the piezoelectric ceramic of the present invention is manufactured in the sintered body.

After that, the input electrodes 20a and 20b as external electrodes and the output electrodes 23a and 23b as external electrodes are formed on both side surfaces of the input portion 16 and the output portion 17 by using a vacuum deposition method or the like. Then, under heating, an electric field is applied for a predetermined time so that the polarization directions are opposite for each layer, and a polarization treatment is performed, thereby producing a piezoelectric transformer.

The ceramic electronic component of the present invention is not limited to the above embodiment. For example, a piezoelectric resonator, a piezoelectric filter, or the like can be used as an example of another ceramic electronic component.

### EXAMPLES

Hereinafter, examples in which the piezoelectric ceramic of the present invention is disclosed more specifically will be shown. Note that, the present invention is not limited to these examples.

### (Sample numbers 1 to 4)

### [Production of Sample]

PbO, ZrO₂, TiO₂, Nb₂O₅, and MnCO₃ were prepared as ceramic raw materials. Then, the above ceramic raw materials were weighed so that the main component composition after firing is PbO (67.80 to 68.63 wt%), ZrO₂ (17.20 to 17.36 wt%), TiO₂ (11.49 to 12.10 wt%), MnO (0.59 to 0.64 wt%), Nb₂O₅ (1.97 to 2.06 wt %). Next, this weighed material was put into a ball mill together with partially stabilized zirconia balls, and wet-mixed and pulverized for 190 minutes. Then, after dehydration and drying, it was calcined at a temperature of 1030°C to produce a ceramic calcined powder.

Next, after crushing the ceramic calcined powder, an organic binder such as a polyvinyl alcohol resin was added, and the mixture was subjected to medialess wet dispersion mixing to produce a slurry. Then, this was spray-dried and the granulated powder for press molding was produced. A ceramic compact was produced by press-molding this granulated powder.

The ceramic compact was put into a sheath, placed in a furnace, and subjected to firing/degreasing treatment. The firing/degreasing treatment was performed in a muffle furnace in an air atmosphere. As the firing profile, the furnace temperature was raised to 450°C at a temperature rising rate of 0.5°C/min, the temperature was held for 2 hours and then lowered at a temperature decreasing rate of 1°C/min or more, 6°C/min or less, thereby completing the firing/degreasing treatment.

Then, main firing (firing step) was performed. As the firing profile, the furnace temperature was raised to 300°C at a temperature rising rate of 3°C/min and held for 1 hour, and when the firing atmosphere was substituted by O₂, the temperature was raised to 1100°C or more, 1150°C or less, when the firing atmosphere was substituted by N₂ or H₂/N₂ mixed gas and WD, raised to 1050°C at 3°C/min, held for 8 hours, and then lowered at a temperature decreasing rate of 1°C/min or more, 6°C/min or less, thereby completing the firing process.

The oxygen concentration in the firing step is as follows. Sample number 1: 1.04 × 10⁻⁹ MPa or more, 1.20 × 10⁻⁸ MPa or less, Sample number 2: 5.74 × 10⁻⁷ MPa or more, 3.28 × 10⁻⁶ MPa or less, Sample number 3: 9.87 × 10⁻² MPa or more, 1.01 × 10⁻¹ MPa or less, Sample No.4: 9.87×10⁻²MPa or more, 1.01×10⁻¹MPa or less.

It was cut into a shape of 13 mm length × 3 mm width × 0.9 mm thickness for evaluation of piezoelectric characteristics by a dicer. The cut sample was subjected to polarization treatment for 30 minutes under conditions of a temperature of 150°C and an electric field strength of 3 kV/mm using an oil bath or the like.

### (Sample numbers 5 and 6)

PbO, ZrO₂, TiO₂, Nb₂O₅ and MnCO₃ were prepared as ceramic raw materials. Then, the above ceramic raw materials were weighed so that the main component composition after firing is PbO (67.80 to 68.63 wt%), ZrO₂ (17.20 to 17.36 wt%), TiO₂ (11.49 to 12.10 wt%), MnO (0.59 to 0.64 wt%), Nb₂O₅ (1.97 to 2.06 wt %). Next, this weighed material was put into a ball mill together with partially stabilized zirconia balls, and wet-mixed and pulverized for 190 minutes. Then, after dehydration and drying, it was calcined at a temperature of 1030°C to produce a ceramic calcined powder.

Next, this ceramic calcined powder was crushed, then a dispersant and a defoaming agent were added, and wet pulverized in a container containing partially stabilized zirconia balls to produce a slurry. The pulverizing time was 12 hours for Sample number 5, and 36 hours for Sample number 6. Then, this slurry was filled in a resin casting mold and dried for 24 hours to give a cast compact.

This cast compact was put into a sheath, placed in a furnace, and subjected to firing/degreasing treatment. The firing/degreasing treatment was performed in a muffle furnace in an air atmosphere. As the firing profile, the furnace temperature was raised to 80°C at a temperature rising rate of 3°C/min, then the temperature was raised to 400°C at a temperature rising rate of 0.25°C/min and held for 2 hours, further the furnace temperature was raised to 600°C at a temperature rising rate of 3°C/min and held for 1 hour, and then the temperature was lowered at a temperature decreasing rate of 1°C/min or more, 5°C/min or less, thereby completing the firing/degreasing treatment.

Then, main firing (firing step) was performed. As the firing profile, the furnace temperature was raised to 300°C at a temperature rising rate of 3°C/min and held for 1 hour, the firing atmosphere was substituted by N₂, and then the furnace temperature was raised to 1050°C at a temperature rising rate of 3°C/min and held for 8 hours, and then the temperature was lowered at a temperature decreasing rate of 1°C/min or more, 6°C/min or less, thereby completing the main firing treatment.

The oxygen concentration in the firing step is as follows. Sample number 5: 5.74×10⁻⁷MPa or more, 3.28×10⁻⁶MPa or less, Sample number 6: 5.74×10⁻⁷MPa or more, 3.28×10⁻⁶MPa or less.

It was cut into a shape of 13 mm length × 3 mm width × 0.9 mm thickness for evaluation of piezoelectric characteristics by a dicer. The cut sample was subjected to polarization treatment for 30 minutes under conditions of a temperature of 150°C and an electric field strength of 3 kV/mm using an oil bath or the like.

### [Sample evaluation]

The grain diameter of the piezoelectric ceramic after sintering was determined by observing the surface of the sample after sintering by SEM, measuring the volume distribution of about 80 grains, and setting it as the D50 value in the case of Heywood diameter. The crystallinity of the piezoelectric ceramic after sintering was evaluated by the centralized method using an X-ray diffractometer with a tube CuKα, a tube voltage of 45 kV, a tube current of 200 mA, a scanning angle of 10-70°, and a sampling width of 0.02°. Among the piezoelectric characteristics, the relative permittivity (ε₃₃^{T}/ε₀) and the electromechanical coupling coefficient k₃₁ in a minute electric field were measured by the resonance-antiresonance method using an impedance analyzer (Agilent Technologies-made: 4294A). The elastic compliance S₁₁^{E} and the limited vibration speed Vₘₐₓ were measured by the constant current measurement method as the piezoelectric characteristics during the resonance large-amplitude driving. After press-molding the sintered piezoelectric ceramic, the composition was identified by fluorescent X-rays analysis, and it was confirmed that at least Pb, Zr, Ti, Mn, and Nb were contained. The manufacturing conditions for each sample number and the evaluation results are summarized in Table 1.

**[Table 1]**

| SAMPLE NUMBER | FIRING ATMOSPHERE | FIRING TEMPERATURE [°C] | PULVERIZATION OF CALCINED POWDER | GRAIN DIAMETER [µm] | ε₃₃^{T}/ε₀ | k₃₁ | Vm ax [m/s] | S₁₁^{E} [× 10⁻¹²m²/N] |
|---|---|---|---|---|---|---|---|---|
| 1 | H₂/N₂+WD | 1050 | NO | 2.2 | 1243 | 0.359 | 0.63 | 12.0 |
| 2 | N₂ | 1050 | NO | 2.4 | 1299 | 0.351 | 0.66 | 12.1 |
| 3 | O₂ | 1100 | NO | 1.1 | 1006 | 0.329 | 0.77 | 11.8 |
| 4 | O₂ | 1150 | NO | 1.1 | 1125 | 0.343 | 0.83 | 11.5 |
| 5 | N₂ | 1050 | YES | 1.1 | 907 | 0.351 | 0.84 | 11.3 |
| 6 | N₂ | 1050 | YES | 1.2 | 920 | 0.355 | 0.86 | 11.2 |

During O₂ firing with a high oxygen partial pressure (oxygen partial pressure: 9.87 × 10⁻² MPa or more, 1.01 × 10⁻¹ MPa or less), since the solid solution of Mn acceptor at the B site of PZT was suppressed and generation of oxygen vacancies promoting the growth of crystal grains was reduced, the grain size was small (Sample numbers 3 and 4) . Sample numbers 3 and 4 exhibited high piezoelectric characteristics and high Vₘₐₓ.

FIG. 4 is an electron microscope photograph of the piezoelectric ceramic produced in Sample number 3. It can be seen that under the O₂ atmosphere, the firing temperature was set to 1100°C or more, resulting in a dense structure as shown in FIG. 4. Further, a higher Vₘₐₓ was exhibited by setting the firing temperature to 1150°C (Sample number 4).

On the other hand, in Sample numbers 5 and 6 in which the grain size was reduced by wet pulverizing the calcined powder, in a low oxygen partial pressure N₂ atmosphere (5.74 × 10⁻⁷ MPa or more, 3.28 × 10⁻⁶ MPa or less) having sintering promotion effect due to increase in oxygen vacancies, the firing temperature was adjusted to 1050°C, which is lower than that at the time of O₂ firing, and it was possible to densify without growing the crystal grains. As a result, high piezoelectric characteristics and high Vₘₐₓ were exhibited.

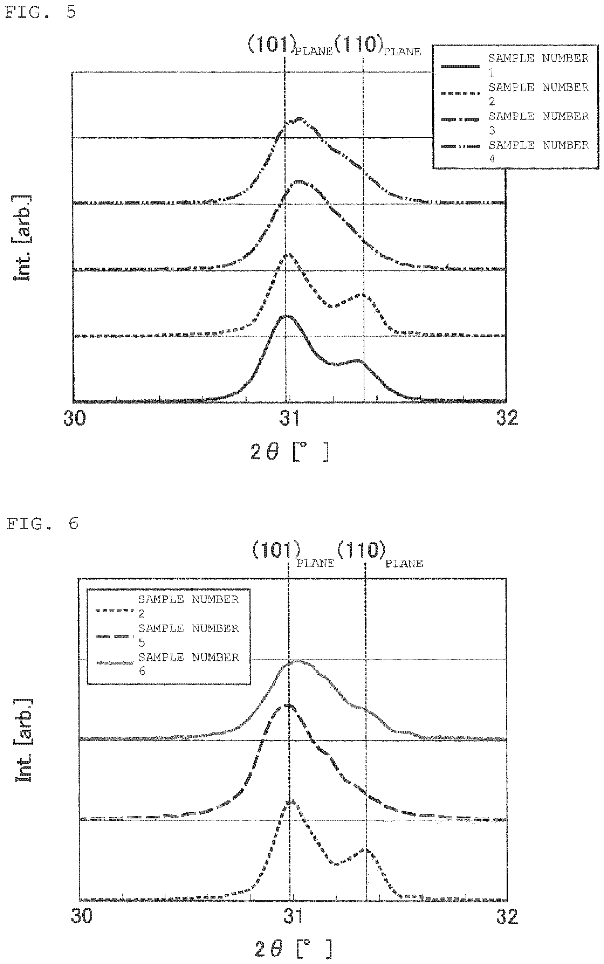

FIG. 5 is a diagram comparing the X-ray diffraction peaks of the piezoelectric ceramic single plates produced in Sample numbers 1 to 4. In order to facilitate the comparison of Sample numbers 1 to 4, the vertical axis is shifted and displayed. In Sample numbers 3 and 4 fired under an oxygen atmosphere, it is known that there is no branching between the X-ray diffraction peak on the (101) plane, which is the main peak of the PZT tetra phase, and the X-ray diffraction peak on the (110) plane, and the number of diffraction patterns is one. On the other hand, in Sample numbers 1 and 2 fired in a low oxygen partial pressure (H₂/N₂ + WD) atmosphere or in a low oxygen partial pressure (N₂) atmosphere, the X-ray diffraction peaks on the (101) and (110) planes are clearly separated. From this, it was found that in Sample numbers 3 and 4, crystallization of the perovskite-type compound was suppressed more than in Sample numbers 1 and 2.

FIG. 6 is a diagram comparing the X-ray diffraction peaks of the piezoelectric ceramic single plates produced in Sample numbers 2, 5 and 6. In order to facilitate the comparison of Sample numbers 2, 5 and 6, the vertical axis is shifted and displayed. In Sample numbers 5 and 6 obtained by pulverizing the ceramic calcined powder and then firing, it is known that there is no branching between the X-ray diffraction peak on the (101) plane, which is the main peak of the PZT tetra phase, and the X-ray diffraction peak on the (110) plane, and the number of diffraction patterns is one. On the other hand, in Sample number 2 in which the ceramic calcined powder was fired without crushing, the X-ray diffraction peaks on the (101) and (110) planes are clearly separated. From this, it was found that the crystallization of the perovskite-type compound was suppressed more in Sample numbers 5 and 6 than in Sample number 2.

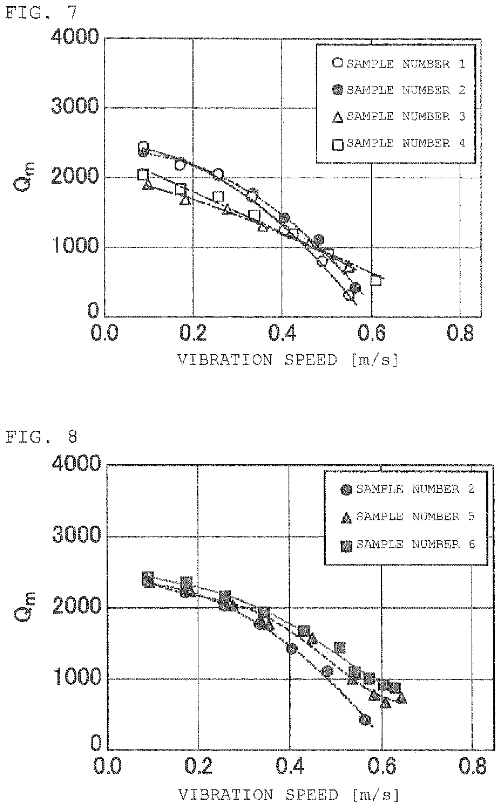

FIG. 7 is a graph showing the relationship between the vibration speed and Qₘ in resonant driving of the piezoelectric ceramic produced in Sample numbers 1 to 4. FIG. 8 is a graph showing the relationship between the vibration speed and Qₘ in resonant driving of the piezoelectric ceramic produced in Sample numbers 2, 5, and 6. From these graphs, it is known that there is no branching between the X-ray diffraction peak on the (101) plane, which is the main peak of the PZT tetra phase, and the X-ray diffraction peak on the (110) plane, there is one diffraction pattern, and the piezoelectric ceramic (Sample numbers 3 to 6) made of a compound with low crystallinity has a high Qₘ value at a high vibration speed (0.5 m/s or more).

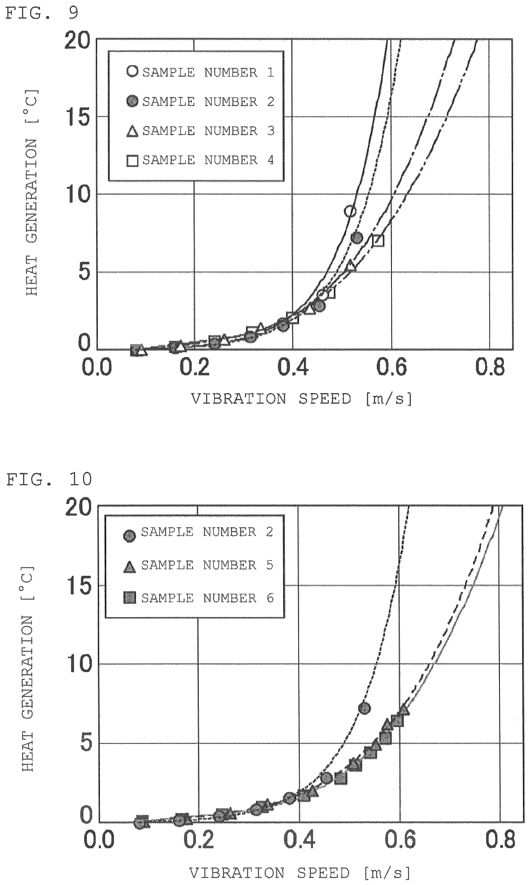

FIG. 9 is a graph showing the relationship between the vibration speed and heat generation in resonant driving of the piezoelectric ceramic produced in Sample numbers 1 to 4. FIG. 10 is a graph showing the relationship between the vibration speed and heat generation in resonant driving of the piezoelectric ceramic produced in Sample numbers 2, 5, and 6. In FIGS. 9 and 10, the vibration speed [m/s] when the heat generation [°C] reaches 20°C is the limited vibration speed Vₘₐₓ. From these graphs, it is known that there is no branching between the X-ray diffraction peak on the (101) plane, which is the main peak of the PZT tetra phase, and the X-ray diffraction peak on the (110) plane, there is one diffraction pattern, and the piezoelectric ceramic (Sample numbers 3 to 6) made of a compound with low crystallinity has a high limited vibration speed Vₘₐₓ.

From Table 1 shown above, the elastic compliance S₁₁^{E} of Sample number 4 densified under the high oxygen partial pressure O₂ firing atmosphere and Sample numbers 5 and 6 produced by pulverizing the calcined powder is smaller than S₁₁^{E} of Sample numbers 1 and 2, which suggests that the piezoelectric ceramic is hardened. In other words, it is difficult for the 90° domain wall to invert, and it is presumed that the Qₘ drop at high vibration speeds (0.5 m/s or more) was suppressed (FIGS. 7 and 8), which increased the limited vibration speed. (FIGS. 9 and 10).

### DESCRIPTION OF REFERENCE SYMBOLS

- 4a-4h:: Piezoelectric body
- 5a-5g:: Internal electrode
- 6:: Laminated sintered body
- 7a, 7b:: External electrode
- 8,11a-11j:: Piezoelectric body
- 9:: Input portion
- 10:: Output portion
- 12a-12i:: Internal electrode
- 13a, 13b:: Input electrode
- 14:: Output electrode
- 15:: Piezoelectric body
- 16:: Input portion
- 17:: Output portion
- 18a-18e, 21a-21i:: Piezoelectric body
- 19a-19d, 22a-22i:: Internal electrode
- 20a, 20b:: Input electrode
- 23a, 23b:: Output electrode

## Claims

1. A piezoelectric ceramic containing a perovskite-type compound containing at least Pb, Zr, Ti, Mn, and Nb, wherein in an X-ray crystal structure analysis chart of the perovskite-type compound, there is no X-ray diffraction peak branching between a (101) plane on which an X-ray diffraction peak, which is a main peak of a PZT tetra phase, is detected in a range of 2θ = 30.5° or more, 31.5° or less and a (110) plane on which an X-ray diffraction peak is detected in a range of 2θ = 30.8° or more, 31.8° or less, and a number of X-ray diffraction peaks appearing based on the (101) plane and the (110) plane is one.

2. The piezoelectric ceramic according to claim 1, wherein one X-ray diffraction peak based on the (101) plane and the (110) plane appears at a position of 2θ = 30.8° or more, 31.2° or less.

3. A ceramic electronic component comprising a piezoelectric body containing the piezoelectric ceramic according to claim 1 or 2, and an external electrode.

4. The ceramic electronic component according to claim 3, wherein the piezoelectric body is a piezoelectric ceramic electronic component which has an input portion and an output portion, and in which a voltage signal supplied to the input portion is output from the output portion with its voltage transformed.

5. A method of manufacturing a piezoelectric ceramic, the method comprising:
a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material;
a molding step of molding the ceramic calcined powder into a ceramic compact; and
a firing step of firing the ceramic compact to obtain a sintered body,
wherein the firing step is performed in a high oxygen atmosphere having an oxygen partial pressure of 9.87 × 10⁻² MPa or more, 1.01 × 10⁻¹ MPa or less.

6. The method of manufacturing a piezoelectric ceramic according to claim 5, wherein a firing temperature in the firing step is 1060°C or more, 1200°C or less.

7. A method of manufacturing a piezoelectric ceramic, the method comprising:
a ceramic calcined powder producing step of producing a ceramic calcined powder by preparing a ceramic raw material containing at least a Pb compound, a Zr compound, a Ti compound, an Mn compound, and an Nb compound, and calcining the ceramic raw material;
a pulverizing step of pulverizing the ceramic calcined powder;
a molding step of molding the pulverized ceramic calcined powder into a ceramic compact; and
a firing step of firing the ceramic compact to obtain a sintered body.

8. The method of manufacturing a piezoelectric ceramic according to claim 7, wherein the firing step is performed in a low oxygen atmosphere using N₂ gas and having an oxygen partial pressure of 5.74 × 10⁻⁷ MPa or more, 3.28 × 10⁻⁶ MPa or less.

9. The method of manufacturing a piezoelectric ceramic according to claim 7, wherein the firing step is performed in a low oxygen atmosphere using both an H₂/N₂ mixed gas and a water drop and having an oxygen partial pressure of 1.04 × 10⁻⁹ MPa or more, 1.20 × 10⁻⁸ MPa or less.

10. The method of manufacturing a piezoelectric ceramic according to any of claims 7 to 9, wherein a firing temperature in the firing step is 1030°C or more, 1200°C or less.

11. The method of manufacturing a piezoelectric ceramic according to claim 7, wherein the firing step is performed in a high oxygen atmosphere having an oxygen partial pressure of 9.87 × 10 ⁻² MPa or more, 1.01 × 10⁻¹ MPa or less.
